# EUROPEAN PATENT SPECIFICATION

(11) **EP 4 145 966 B1**
(45) Date of publication and mention of the grant of the patent: **24.04.2024**
(21) Application number: 21838403.0
(22) Date of filing: 01.06.2021
(51) Int. Cl.: G08B 13/19, H05K 5/02, H05K 5/06

(54) **OUTDOOR SENSING DEVICE**
AUSSENERFASSUNGSVORRICHTUNG
DISPOSITIF DE DÉTECTION EXTÉRIEUR

(30) Priority: 08.07.2020 JP 2020117793
(43) Date of publication of application: 08.03.2023
(73) Proprietor: Optex Co., Ltd., Otsu-shi, Shiga 520-0101 (JP)
(72) Inventor: IKEDA, Hiroyuki, Otsu-shi, Shiga 520-0101 (JP)
(74) Representative: Herrero & Asociados, S.L.
(86) International application number: PCT/JP2021/020816
(87) International publication number: WO 2022/009562

(56) References cited:
- CN-U- 209 357 195
- JP-A- H11 310 277
- JP-A- 2007 102 555
- US-A- 5 377 076
- US-A1- 2005 219 046

## Description

### CROSS REFERENCE TO THE RELATED APPLICATION

This application is based on and claims Convention priority to Japanese patent application No. 2020-117793, filed July 8, 2020.

### BACKGROUND OF THE INVENTION

### (Field of the Invention)

The present invention relates to an outdoor sensing device configured to detect an object such as a suspicious person or an intruder in an outdoor environment.

### (Description of Related Art)

Conventionally, sensing devices such as crime prevention devices have been used to sense to-be-sensed rays such as infrared rays to detect objects such as suspicious persons and intruders in order to determine the presence or absence of such objects. In recent years, there is a growing demand for sensing devices that can be used outdoors in order to detect suspicious persons, intruders, or the like early and/or that include a camera so that an image can be taken in conjunction with sensing and be sent and checked. In the case where a sensing device is used outdoors, the device may be exposed to the elements, so that a liquid such as raindrops or the like (hereinafter, also simply referred to as "water") from outside of the device could enter through partings or the like between components of a device enclosure or an outer cover (also simply referred to as the "enclosure" or "outer cover" collectively) which is opened and closed for installation and adjustment of the device. In addition, outdoor sensing devices may experience fluctuations in the internal pressure in their internal space in association with the environmental temperature variation depending on the seasons and on the day and night, so that moisture-laden outside air is sucked in. This in turn causes the devices to be subjected to environmental temperature variation again, possibly causing dew condensation inside the devices. Such water ingress and/or dew condensation may cause a failure or malfunction in a sensing element for sensing to-be-sensed rays or a processing circuit for processing signals from the sensing element, or may cause, in devices including a camera, a problem that dews are unintentionally included in a captured image to make the image unclear. Outdoor electrical equipment including such devices is required to have performance that meets the IP (Ingress Protection) standards defining dustproof performance and waterproof performance.

Conventional outdoor electrical equipment is known to include a water drain hole at the lower end of the enclosure, the water drain hole configured to drain the water intruded into the enclosure from outside and/or dew formed inside the enclosure to the outside as described in Patent Document 1.

### [Related Document]

### [Patent Document]

[Patent Document 1] JP Laid-open Patent Publication No. 2018-113416.

The document US2005219046A1 2005-10-06 discloses a pyroelectric motion detector with Fresnel lens that has a sealed inner housing and an outer housing to prevent ingress of water.

### SUMMARY OF THE INVENTION

The outdoor equipment of Patent Document 1 includes a slit having a width of 0.3 to 0.5 mm and having an elongated shape so as to efficiently drain water as a drainage hole. Such a drain hole can prevent entry of foreign objects including insects larger than the size of the slit. However, a mold for forming a slit having a width of 0.3 to 0.5 mm tends to be expensive because high precision is required. In addition, removal of an enclosure with a slit from a mold must be performed carefully and thus is troublesome.

Some conventional outdoor sensing devices include a hole in the bottom wall of the outer cover and a ventilation function film (moisture permeable film) attached to the inside of the enclosure so as to cover the hole for the purpose of preventing entry of foreign objects including insects or the like (also called as specific intruding objects). In this case, this hole only permits discharge of water vapor (gas) through the moisture permeable film and cannot discharge water (liquid). Therefore, it normally permits ventilation for adjusting an air pressure difference between the inside and outside of the device and discharging moisture, whereas ventilation obstruction may occur when water droplets accumulate on the moisture permeable film.

Some other conventional outdoor sensing devices include, in the bottom wall of the device enclosure, a cover hole through which a rotary member for opening and closing the enclosure is inserted, the rotary member loosely fitted to the cover hole (for example, with a gap (fitting tolerance) of 0.2 mm or smaller for the purpose of preventing entry of specific intruding objects). Water inside the device can be discharged from the gap between the rotary member and the cover hole. Since the bottom wall of the device enclosure is flat, however, any water remaining in an area around and away from the cover hole inside the device is less likely to be drained directly, and typically it is not until the water is vaporized that the water is discharged from the gap between the rotary member and the cover hole. A possible way to directly discharge the water before vaporization may be, for example, to include a tapered part (inclined part) inclined toward the cover hole as a guide part for guiding water on the bottom wall of the enclosure. In this case, the external appearance (hereinafter also referred to as "external design" or simply as "design") of the enclosure or the outer cover also includes a shape corresponding to the tapered shape, so that the external design is affected by the shape of the tapered part for drainage.

Conventional indoor ceiling-mounted sensors include an inclined part (tapered part) in the base part by which the main body is attached, and an opening for drainage is provided at the tip of the inclination in such a position that dripping onto the main body part is avoided, so as to prevent ingress of water via the wiring from the ceiling space into the main body. This structure is intended to be mounted to the ceiling in an indoor environment to prevent such water ingress via the wiring into the main body and cannot be readily adopted into outdoor devices.

Therefore, an object of the present invention is to provide an outdoor sensing device having a structure which can prevent ingress of specific intruding objects, directly drain intruded water and dew inside the main body of the device, and further have enhanced freedom in design without limiting the external design in order to solve the above problems of the conventional technology.

As a result of various studies, the present inventor found that the above-mentioned object can be achieved by the present invention described below.

The present invention provides an outdoor sensing device including:
a functional unit including a sensing element configured to sense to-be-sensed rays from an object through an optical member and a processing circuit configured to process a signal from the sensing element;
a cover unit including an inner cover which has a predetermined dimension and houses the functional unit, and an outer cover which houses the inner cover; and
a base unit to which the functional unit and the cover unit are attached, the base unit configured to be installed in an outside installation position,
wherein the inner cover includes a water ingress prevention structure disposed between the functional unit and the optical member to prevent water ingress from outside of the inner cover, and further includes a drain hole and a guide part configured to guide the water toward the drain hole on a bottom wall of the inner cover, and
the outer cover has a bottom wall which defines a predetermined gap with respect to the bottom wall of the inner cover, and the bottom wall of the outer cover includes a drain part configured to drain the water from the drain hole to outside of the outdoor sensing device and includes a blind structure which covers the drain hole of the inner cover such that the drain hole cannot be seen from the outside of the outdoor sensing device when viewed from below.

According to this configuration, the outdoor sensing device of the present invention includes the water ingress prevention structure between the functional unit and the optical member and thus can demonstrate adequate performance in terms of waterproofing and the like. Since the inner cover includes, for example, a tapered guide part and the bottom wall of the outer cover defines a predetermined gap with respect to the bottom wall of the inner cover, and the inner cover has a predetermined dimension, the outdoor sensing device can directly drain water in case of water ingress into a main body of the device (when employing the water ingress prevention structure) as well as dew (including water accumulating in an area around and away from the drain hole) through the drain hole and the drain part, and can prevent ingress of, for example, specific intruding objects. These features that the bottom wall of the outer cover defines a predetermined gap with respect to the bottom wall of the inner cover and further the inner cover has a predetermined dimension eliminate the necessity of forming a slit having a width of 0.3 to 0.5 mm. Therefore, there is no need to use a mold designed to form such a slit, so that the manufacturing cost and labor can be reduced as compared with the case where such a mold is used. Further, thanks to use of the double structure cover unit including the inner cover and the outer cover housing the inner cover, the shape of the bottom wall of the outer cover is not affected by, for example, the tapering or the like of the inner cover, and the external design is not limited, enhancing freedom in design.

The predetermined gap may be smaller than a dimension of a specific intruding object. The predetermined dimension may be set such that a gap between the inner cover and the outer cover is smaller than a dimension of a specific intruding object. This makes it possible to prevent ingress of specific intruding objects.

The guide part configured to guide the water toward the drain hole may be a tapered structure. Thus, the water can be guided toward the drain hole.

The water ingress prevention structure may be a structure including watertight packing between the inner cover and the functional unit and between the inner cover and the optical member. Thus, waterproofing can be easily achieved.

The bottom wall of the inner cover may have a shape different from that of the bottom wall of the outer cover. In this way, it is possible to enhance freedom in design without limiting the external design.

The present invention is defined by the appended claims.

### BRIEF DESCRIPTION OF THE DRAWINGS

The present invention will be more clearly understood from the following description of preferred embodiments thereof, when taken in conjunction with the accompanying drawings. However, the embodiments and the drawings are given only for the purpose of illustration and explanation, and are not to be taken as limiting the scope of the present invention in any way whatsoever, which scope is to be determined by the appended claims. In the accompanying drawings, like reference numerals are used to denote like or corresponding parts throughout the several views.
Fig. 1 is an external view of a sensing device for outdoor use according to one embodiment of the present invention;
Fig. 2 is a bottom view showing the external appearance of the sensing device;
Fig. 3 shows the inside of the cover unit of the sensing device;
Fig. 4 shows a main part which is the lower part of Fig. 3 in detail;
Fig. 5 is an exploded view of the sensing device;
Fig. 6 shows the front face of the inner cover which is a part of the cover unit as viewed from diagonally below; and
Fig. 7 shows a main part of Fig. 4 in detail to illustrate the structural relation between the inner cover and the outer cover which are parts of the cover unit.

### DESCRIPTION OF THE EMBODIMENTS

Hereinafter, one embodiment of the present invention will be described with reference to the drawings. It should be noted that same reference signs in the drawings denote same or corresponding parts, and description therefor is omitted unless changes or the like need to be specifically described.

### <Sensing Device>

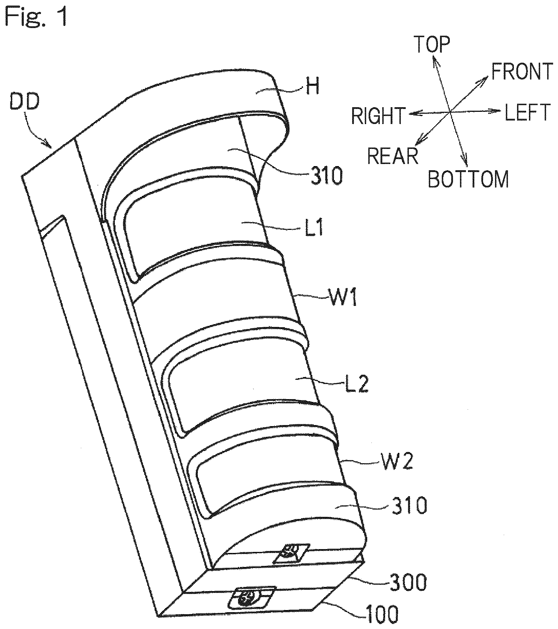

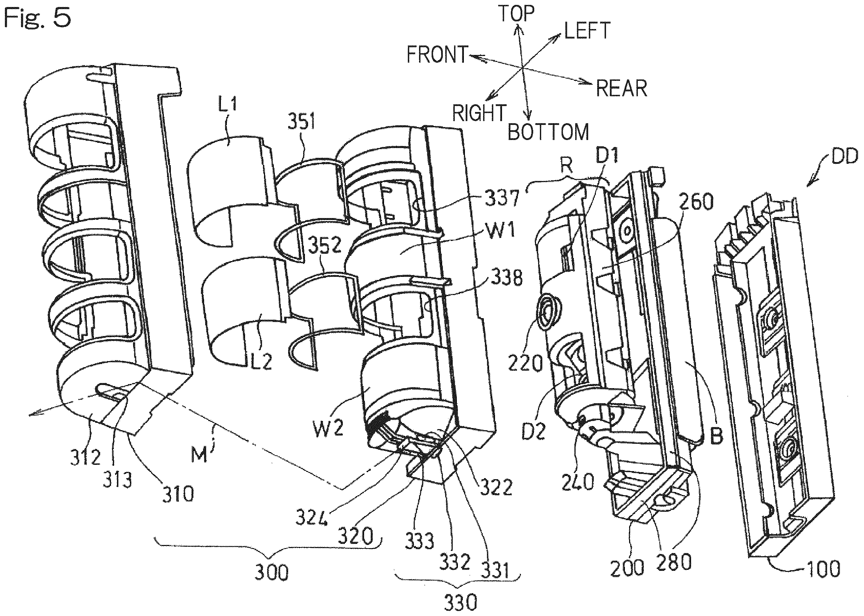

Fig. 1 shows a sensing device DD for outdoor use according to one embodiment of the present invention as viewed from diagonally below. The sensing device DD senses, for example, infrared rays as to-be-sensed rays to detect an object such as a suspicious person or an intruder in an outdoor environment. The sensing device DD includes an optical system such as a Fresnel lens or optical members L1 (upper) and L2 (lower) as windows for effectively transmitting required light (electromagnetic wave), which are attached to an outer cover 310 of a cover unit 300. The sensing device DD also includes, for example, far-infrared sensing elements D1, D2 (Fig. 5) inside the curved optical members L1 and L2. The sensing device DD may also include an imaging unit (device) such as a camera and an LED (Light Emitting Diode) which provides supplementary illuminating light for imaging using a camera to take an image of an object such as an intruder and/or detect such an object.

### <Configuration of Sensing Device>

The sensing device DD shown in Fig. 1 at least includes: a functional unit 200 including the sensing elements D1, D2 which sense to-be-sensed rays from an object through the optical members L1, L2 and a processing circuit 260 shown in Fig. 5 which processes a signal from the sensing elements; a cover unit 300 fitted to the functional unit 200 and including an inner cover 320 which covers the functional unit (i.e., houses the entirety or a part of the functional unit 200) and an outer cover 310 which houses the entirety or a part of the inner cover; and a base unit 100 to which the functional unit 200 and the cover unit 300 are attached directly or indirectly and which allows the device DD to be installed in an installation position in an outdoor environment, such as a position on a wall surface. The sensing device DD includes a camera window W1 and an LED window W2 which are exposed to the outside of the device as described below. As shown in Fig. 1, the sensing device DD may include, in an upper part thereof, a hood H as illustrated in Fig. 1 only.

### <Details of Constituting Members of Sensing Device>

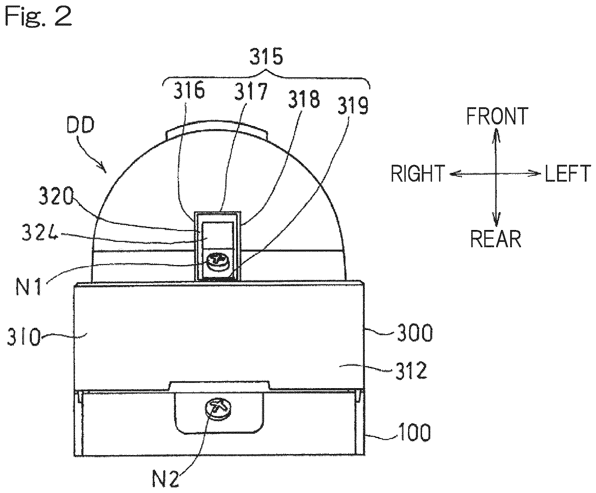

On the outer-cover bottom wall 312 of the outer cover 310 in the lower part of the sensing device DD shown in Fig. 2, an inner-cover protrusion 324 of the inner cover 320 is exposed to the outside the device from the outer cover 310. The inner-cover protrusion 324 has a threaded hole into which a screw N1 is inserted to fasten the functional unit 200 (Fig. 5) and the cover unit 300 with the screw. The outer-cover bottom wall 312 has a threaded hole into which a screw N2 is inserted to fasten the functional unit 200 and the cover unit 300 to the base unit 100 with the screw. The inner-cover protrusion 324 is loosely fitted into a rectangular hole 313 (Fig. 5) in the outer-cover bottom wall 312 (as indicated by arrow M in Fig. 5). A cover gap 315 including small cover gap portions 316 to 319 (typically having a predetermined gap as described later) is defined between the inner-cover protrusion 324 and the rectangular hole 313 of the outer-cover bottom wall 312 to provide a drain part for draining water from the drain hole 330 of the inner cover 320 as described later to the outside of the sensing device DD. As shown in Fig. 2, the drain hole 330 of the inner cover 320 cannot be seen from the outside of the sensing device DD when viewed from below. The outer-cover bottom wall 312 serves as a blind structure which covers the drain hole 330 of the inner cover 320 such that the drain hole 330 cannot be seen from the outside of the sensing device DD when viewed from below.

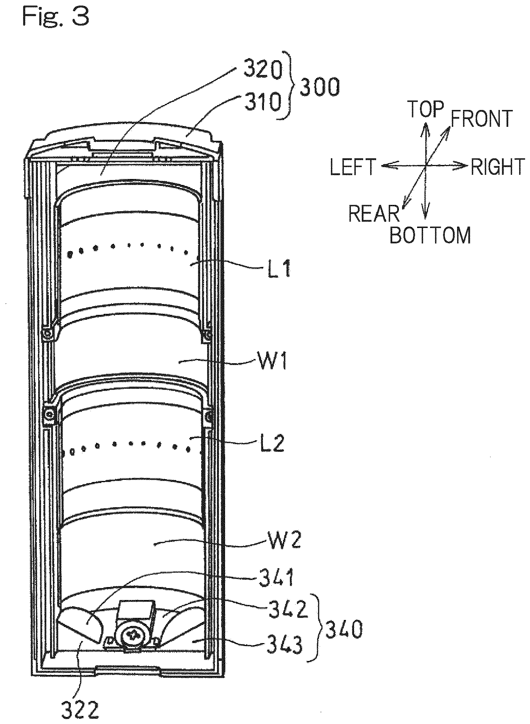

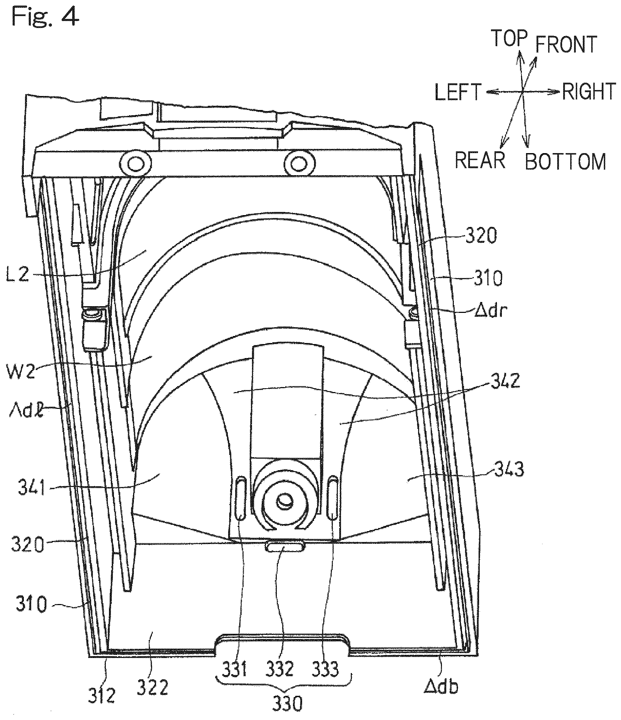

Fig. 3 shows the inner side of the cover unit 300 of the sensing device DD, in which the outer cover 310 houses the inner cover 320 therein. That is, the cover unit 300 of the sensing device DD according to the present embodiment has a double structure including the inner cover 320 and the outer cover 310. Fig. 4 shows a main, lower inner part of Fig. 3, which shows that the drain hole 330 includes a left drain hole portion 331, a rear drain hole portion 332 (illustrated nearer in the figure) and a right drain hole portion 333 in the inner-cover bottom wall 322 of the inner cover 320 and further that a tapered part 340 serving as a guide part for guiding the water toward the drain hole 330 includes a left tapered portion 341, a front tapered portion 342 (illustrated farther in the figure) and a right tapered portion 343. The tapered portions 341, 342, 343 are inclined so as to drain water toward the drain hole portions 331, 332, 333. Thus, they can also directly drain, in addition to evaporated water vapor, water accumulating in an area around and somewhat away from the drain hole 330. The inner cover 320 has a predetermined dimension so as to define small gaps Δdl, Δdr, etc., between the inner cover and the outer cover 310, the small gaps being smaller than the dimension of a specific intruding object (for example, 0.2 mm or smaller in order to prevent entry of specific intruding objects), and thus is received inside the outer cover 310. In addition, a predetermined gap Δdb smaller than the dimension of a specific intruding object (for example, 0.2 mm or smaller in order to prevent entry of specific intruding objects) is defined between the outer-cover bottom wall 312 of the outer cover 310 and the inner-cover bottom wall 322 of the inner cover 320. This configuration makes it difficult for specific intruding objects to intrude, even through the drain hole portions 331, 332, 333 have larger dimensions than those of the cover gap 315, the small gaps Δdl, Δdr, etc., and the predetermined gap Δdb. It should be noted that although the predetermined gap between the respective bottom walls of the inner cover and the outer cover is specifically defined separate from the predetermined dimension, the predetermined gap may be regarded as being included in the predetermined dimension. The small gaps and the predetermined gap may have the same size or different sizes.

Fig. 5 shows an exploded view of the sensing device DD dissembled in the front-to-rear direction and generally illustrates, from the rear to the front, the base unit 100, the functional unit 200, and the inner cover 320 and the outer cover 310 of the cover unit 300 in an exploded manner. The functional unit 200 includes a rotary unit R which can be turned to the left and right on the front face of the functional unit and a power supply circuit B such as a battery box and a stepdown circuit on the rear face of the functional unit. On the front face of the rotary unit R are arranged the sensing element D1, the camera 220 of the imaging unit, the LED 240 which provides supplementary illuminating light, and the sensing element D2 in this order from the top to the bottom. On the rear face of the rotary unit R are arranged the processing circuit 260 which processes signals from the sensing elements D1, D2 in response to sensing of to-be-sensed rays from an object through the optical members L1, L2 and signals from the camera 220, and the control circuit (not illustrated) which controls the camera 220 and the LED240, and the like. Packing 280 which is a watertight member is arranged between the inner cover 320 and the peripheral part of the rear face of the functional unit 200 at which the functional unit is fitted to the cover unit 300 (more specifically, the inner cover 320). As shown in Fig. 5, the bottom wall 322 of the inner cover 320 including the inclined tapered part 340 has a shape different from that of the substantially flat bottom wall 312 of the outer cover 310.

In Fig. 5, the optical members L1, L2 and the watertight packing 351, 352 are shown between the inner cover 320 and the outer cover 310. The optical member L1 is received in an opening part 337 of the inner cover 320 for the sensing element D1, with the packing 351 placed therebetween, and is pressed against the inner cover 320 by the outer cover 310. The optical member L2 is received in an opening part 338 of the inner cover 320 for the sensing element D2, with the packing 352 placed therebetween, and is pressed against the inner cover 320 by the outer cover 310. The inner cover 320 can achieve watertight fitting by the above-described packing 351, 352, the watertight packing 280 and the like and thus has a water ingress prevention structure for preventing water ingress from the outside of the inner cover 320 between the functional unit 200 and the optical members L1, L2. The camera window W1 and the lighting window W2 are incorporated in the inner cover 320 and are located in corresponding positions to the camera 220 and the illuminating LED 240, respectively, of the functional unit 200.

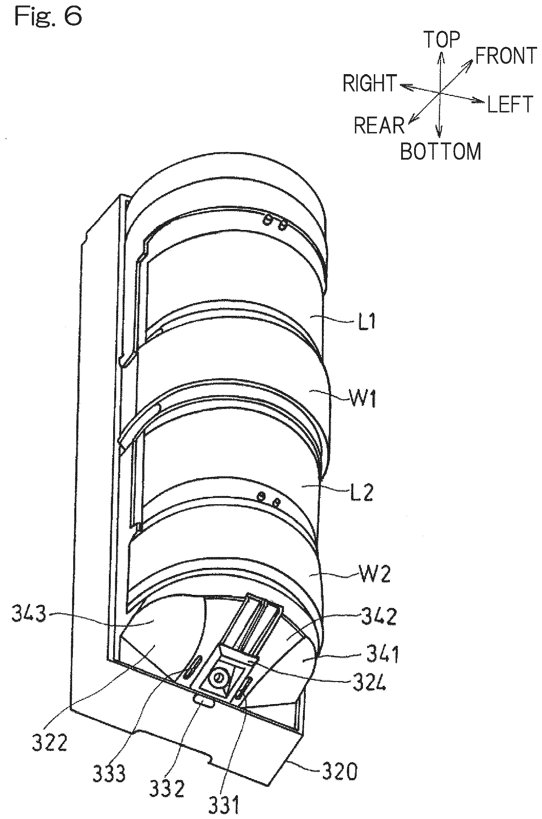

Fig. 6 shows the front face of the inner cover 320 as viewed from diagonally below. The inner cover 320 is attached with the optical members L1, L2 and the LED window W2 and includes the camera window W1 in an incorporated manner. On the bottom wall 322, the shape of the tapered part 340 (tapered portions 341, 342, 343) located inside is seen as the external shape of the inner cover 320. In addition, the bottom wall 322 includes the drain hole portions 331, 332, 333 which penetrate from the inside to the outside. The bottom wall 322 also includes the inner-cover protrusion 324.

### <Effect and Advantage of the Above Configuration of Sensing Device>

Generally, in a sensing device for outdoor use, temperature change is most likely to occur in the optical system (optical members) which directly face the outside and is designed to be thin or in the LED window which transmits nearinfrared rays and/or far-infrared rays. These parts are often fitted to the cover in some way. Condensation tends to occur in these locations, and condensation water runs along the inner surface to the bottom surface inside the cover. Therefore, if that water can be quickly discharged to the outside, problems caused by internal condensation can be avoided. Thanks to the above-described structure, the sensing device DD for outdoor use according to the present embodiment can quickly and directly discharge condensation water to the outside and can also quickly and directly discharge a liquid such as raindrops to the outside in the case of ingress of the raindrops from outside of the device.

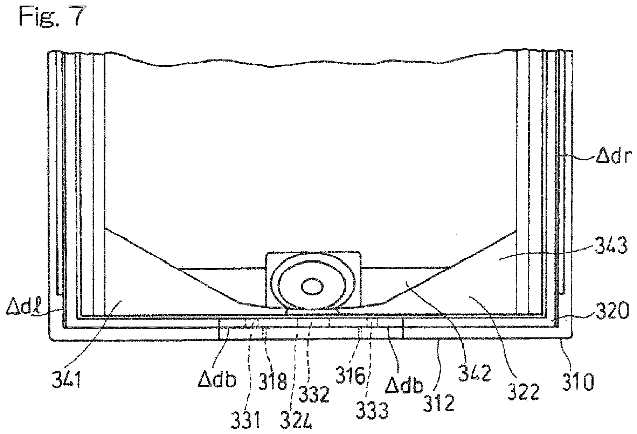

In addition, as shown in Fig. 7, the outer cover 310 is loosely fitted to the inner cover 320 having a predetermined dimension so as to define the small gaps Δdl, Δdr as described above. Further, the predetermined gap Δdb smaller than the dimension of a specific intruding object is defined between the outer-cover bottom wall 312 of the outer cover 310 and the inner-cover bottom wall 322 of the inner cover 320. This makes it possible to quickly drain condensation water and the like to the outside and prevent ingress of specific intruding objects. As described above, the cover gap 315 including the small cover gap portions 316 to 319, typically having the predetermined gap Δdb, is defined between the inner-cover protrusion 324 and the rectangular hole 313 (Fig. 5) of the outer-cover bottom wall 312, and the water is drained through these gap portions to the outside of the sensing device DD.

The sensing device DD according to the present embodiment is structured such that the outer cover 310 covers and conceals the drain hole 330 (drain hole portions 331, 332, 333) of the inner cover 320 from outside, so that the drain hole 330 of the inner cover 320 cannot be directly seen by an outsider, enhancing reliability of the sensing device which is a crime prevention device or the like.

In addition, the bottom wall 312 of the outer cover 31 defines the predetermined gap Δdb with respect to the bottom wall 322 of the inner cover 320, and the inner cover has a predetermined dimension so as to define the small gaps Δdl, Δdr, etc. This can reduce the manufacturing cost and labor considering that, for example, a mold for forming slits having a width of 0.3 to 0.5 mm is difficult to produce, and manufacturing by resin molding is difficult because resin molding tends to produce defects such as burr formation due to the slit parts having a small width dimension.

Thanks to use of the double structure cover unit 300 including the inner cover 320 and the outer cover 310, although the shape of the inner-cover bottom wall 322 is affected by the shape of the tapered part 340 for water drainage formed on the bottom wall 322 of the inner cover 320, the shape of the bottom wall 312 of the outer cover is not affected by the shape of the tapered part, so that freedom in design can be enhanced as compared with the case of a single structure cover. In addition, conventionally, if the outer cover is changed to produce a product having a different design, the protection structure must be reevaluated or reviewed because the outer cover functions as the protection structure. In the present embodiment, however, the inner cover functions as the protection structure, so that the design of the outer cover can be changed without considering the protection structure. This can eliminate the necessity for reevaluating the protection structure.

Further, the above configuration of the present embodiment also provides the following secondary effects. Conventionally, in the case of a single structure cover, it has been important to minimize the number of areas which require a waterproofing function in the watertight interface where the cover (which corresponds to the outer cover 310 of the present embodiment), a lens (optical members), and a holder for the lens are fitted for cost down of products. For this reason, it has been appropriate to provide waterproofing between the cover and the lens (i.e., an external part of the lens). In this case, a watertight member is placed or an adhesive or the like is filled between the lens and the cover. When a sensing device for outdoor use is splashed with a jet of a liquid from outside, the jet may reach the gap between the lens and the cover and may directly strike these waterproofing members. Therefore, if the above-mentioned watertight member is not held uniformly or the adhesive or the like is not applied uniformly, water could enter from the areas where the waterproofing is insufficient.

In the present embodiment, however, the double structure cover unit 300 includes the inner cover 320, and the optical member L1 is attached to the inner cover 320 with the packing 351 placed therebetween (that is, waterproofing is provided at an internal part of the optical member L1). Thus, a jet of a liquid does not directly strike the packing 351. That is, the force of the jet reaching the packing 351 is weakened thanks to the structure. The jet from outside passes through the gap between the outer cover 310 and the lens, then flows along the surface of the outer lens 310, bypasses the end face of the outer lens 310 to the opposite face, and then reaches the watertight interface between the lens and the inner cover 320. Thus, unlike the conventional lens holder, the jet does not directly strike the packing 351. Further, the flow path in the present embodiment is more complicated than in the conventional device, so that the force of the jet to pass through the packing can be made weaker, reducing the possibility of water ingress.

Although the present invention has been described in terms of the preferred embodiments thereof with reference to the drawings, the present invention is not limited to the above-described embodiment, and various additions, modifications, or deletions may be made without departing from the scope of the claims.

Accordingly, such variants are included within the scope of the present invention.

### [Reference Numerals]

- 100: base unit
- 200: functional unit
- 260: processing circuit
- 280: packing (water ingress prevention structure)
- 300: cover unit
- 310: outer cover
- 312: outer-cover bottom wall
- 315: cover gap (drain part)
- 320: inner cover
- 322: inner-cover bottom wall
- 330: drain hole
- 340: tapered part (guide part)
- 351, 352: packing (water ingress prevention structure)
- D1, D2: sensing element
- DD: (outdoor) sensing device
- L1, L2: Fresnel lens (optical member)

## Claims

1. An outdoor sensing device (DD) comprising:
a functional unit (200) including a sensing element (D1) configured to sense to-be-sensed rays from an object through an optical member (L1) and a processing circuit (260) configured to process a signal from the sensing element;
a cover unit (300) including an inner cover (320) which has a predetermined dimension and houses the functional unit, and an outer cover (310) which houses the inner cover; and
a base unit (100) to which the functional unit and the cover unit are attached, the base unit configured to be installed in an outside installation position,
wherein the inner cover includes a water ingress prevention structure (280, 351, 352) disposed between the functional unit and the optical member to prevent water ingress from outside of the inner cover, and further includes a drain hole (330-333) and a guide part (340-343) configured to guide the water toward the drain hole on a bottom wall of the inner cover, and
the outer cover has a bottom wall (312) which defines a predetermined gap with respect to the bottom wall of the inner cover, and the bottom wall of the outer cover includes a drain part (315.319) configured to drain the water from the drain hole to outside of the outdoor sensing device and includes a blind structure which covers the drain hole of the inner cover such that the drain hole cannot be seen from the outside of the outdoor sensing device when viewed from below.

2. The outdoor sensing device as claimed in claim 1, wherein the predetermined gap is smaller than a dimension of a specific intruding object.

3. The outdoor sensing device as claimed in claim 1 or 2, wherein the predetermined dimension is set such that a gap between the inner cover and the outer cover is smaller than a dimension of a specific intruding object.

4. The outdoor sensing device as claimed in any one of claims 1 to 3, wherein the water ingress prevention structure is a structure including watertight packing between the inner cover and the functional unit and between the inner cover and the optical member.

5. The outdoor sensing device as claimed in any one of claims 1 to 4, wherein the guide part configured to guide the water toward the drain hole is a tapered structure.

6. The outdoor sensing device as claimed in any one of claims 1 to 5, wherein the bottom wall of the inner cover has a shape different from that of the bottom wall of the outer cover.

## Patentansprüche

1. Außenerfassungsvorrichtung (DD), umfassend:
eine Funktionseinheit (200), die ein Erfassungselement (D1), das so ausgestaltet ist, dass es zu erfassende Strahlen von einem Objekt durch ein optisches Element (L1) erfasst, und eine Verarbeitungsschaltung (260), die so ausgestaltet ist, dass sie ein Signal von dem Erfassungselement verarbeitet, umfasst;
eine Abdeckungseinheit (300), die eine Innenabdeckung (320), die eine vorgegebene Abmessung aufweist und die Funktionseinheit aufnimmt, und eine Außenabdeckung (310), die die Innenabdeckung aufnimmt, umfasst; und
eine Basiseinheit (100), an der die Funktionseinheit und die Abdeckungseinheit befestigt sind, wobei die Basiseinheit ausgestaltet ist, in einer Außeninstallationsposition installiert zu sein,
wobei die Innenabdeckung eine Wassereintrittsverhinderungsstruktur (280, 351, 352) umfasst, die zwischen der Funktionseinheit und dem optischen Element angeordnet ist, um einen Wassereintritt von einer Außenseite der Innenabdeckung zu verhindern, und ferner eine Ablassöffnung (330-333) und einen Führungsteil (340-343), der so ausgestaltet ist, dass er das Wasser an einer Bodenwand der Innenabdeckung hin zu der Ablassöffnung führt, umfasst, und
wobei die Außenabdeckung eine Bodenwand (312) aufweist, die einen vorgegebenen Spalt in Bezug auf die Bodenwand der Innenabdeckung definiert, und die Bodenwand der Außenabdeckung einen Ableitungsteil (315.319) umfasst, der so ausgestaltet ist, dass er das Wasser aus der Ablassöffnung zur Außenseite der Außenerfassungsvorrichtung ableitet, und der eine Blendenstruktur umfasst, die die Ablassöffnung der Innenabdeckung bedeckt, sodass die Ablassöffnung von der Außenseite der Außenerfassungsvorrichtung, bei Betrachtung von unten, nicht sichtbar ist.

2. Außenerfassungsvorrichtung nach Anspruch 1, wobei der vorgegebene Spalt kleiner als eine Abmessung eines bestimmten eindringenden Objekts ist.

3. Außenerfassungsvorrichtung nach Anspruch 1 oder 2, wobei die vorgegebene Abmessung so festgelegt ist, dass ein Spalt zwischen der Innenabdeckung und der Außenabdeckung kleiner als eine Abmessung eines bestimmten eindringenden Objekts ist.

4. Außenerfassungsvorrichtung nach einem beliebigen der Ansprüche 1 bis 3, wobei die Wassereintrittsverhinderungsstruktur eine Struktur ist, die eine wasserfeste Dichtung zwischen der Innenabdeckung und der Funktionseinheit und zwischen der Innenabdeckung und dem optischen Element umfasst.

5. Außenerfassungsvorrichtung nach einem beliebigen der Ansprüche 1 bis 4, wobei der Führungsteil, der so ausgestaltet ist, dass er das Wasser hin zu der Ablassöffnung führt, eine sich verjüngende Struktur ist.

6. Außenerfassungsvorrichtung nach einem beliebigen der Ansprüche 1 bis 5, wobei die Bodenwand der Innenabdeckung eine Form aufweist, die sich von der der Bodenwand der Außenabdeckung unterscheidet.

## Revendications

1. Dispositif de détection d'extérieur (DD) comprenant :
une unité fonctionnelle (200) comprenant un élément de détection (D1) configuré pour détecter des rayons à détecter émanant d'un objet par l'intermédiaire d'un organe optique (L1) et un circuit de traitement (260) configuré pour traiter un signal provenant de l'élément de détection ;
une unité de recouvrement (300) comprenant un couvercle intérieur (320) qui présente une dimension prédéterminée et loge l'unité fonctionnelle, et un couvercle extérieur (310) qui loge le couvercle intérieur ; et
une unité de base (100) à laquelle l'unité fonctionnelle et l'unité de recouvrement sont fixées, l'unité de base étant configurée pour être installée dans une position d'installation extérieure,
dans lequel le couvercle intérieur comprend une structure de prévention de pénétration d'eau (280, 351, 352) disposée entre l'unité fonctionnelle et l'organe optique pour empêcher toute pénétration d'eau depuis l'extérieur du couvercle intérieur, et comprend en outre un orifice d'évacuation (330-333) et une partie de guidage (340-343) configurée pour guider l'eau vers l'orifice d'évacuation sur une paroi inférieure du couvercle intérieur, et
le couvercle extérieur présente une paroi inférieure (312) qui définit un écartement prédéterminé par rapport à la paroi inférieure du couvercle intérieur, et la paroi inférieure du couvercle extérieur comprend une partie d'évacuation (315-319) configurée pour évacuer l'eau de l'orifice d'évacuation vers l'extérieur du dispositif de détection d'extérieur et comprend une structure aveugle qui recouvre l'orifice d'évacuation du couvercle intérieur de sorte que l'orifice d'évacuation ne puisse pas être vu depuis l'extérieur du dispositif de détection d'extérieur en vue de dessous.

2. Dispositif de détection d'extérieur selon la revendication 1, dans lequel l'écartement prédéterminé est plus petit qu'une dimension d'un objet d'intrusion spécifique.

3. Dispositif de détection d'extérieur selon la revendication 1 ou 2, dans lequel la dimension prédéterminée est définie de sorte qu'un écartement entre le couvercle intérieur et le couvercle extérieur soit plus petit qu'une dimension d'un objet d'intrusion spécifique.

4. Dispositif de détection d'extérieur selon l'une quelconque des revendications 1 à 3, dans lequel la structure de prévention de pénétration d'eau est une structure comprenant une garniture étanche à l'eau entre le couvercle intérieur et l'unité fonctionnelle et entre le couvercle intérieur et l'organe optique.

5. Dispositif de détection d'extérieur selon l'une quelconque des revendications 1 à 4, dans lequel la partie de guidage configurée pour guider l'eau vers l'orifice d'évacuation est une structure conique.

6. Dispositif de détection d'extérieur selon l'une quelconque des revendications 1 à 5, dans lequel la paroi inférieure du couvercle intérieur présente une forme différente de celle de la paroi inférieure du couvercle extérieur.
